# EUROPEAN PATENT SPECIFICATION

(11) **EP 4 592 773 B1**
(45) Date of publication and mention of the grant of the patent: **16.09.2026**
(21) Application number: 24154049.1
(22) Date of filing: 25.01.2024
(51) Int. Cl.: G05B 19/042, G05B 19/4067, G06F 1/30

(54) **POWER DOWN CIRCUITRY**
ABSCHALTSCHALTUNG
CIRCUIT DE MISE HORS TENSION

(43) Date of publication of application: 30.07.2025
(73) Proprietor: ABB SCHWEIZ AG, 5400 Baden (CH)
(72) Inventor: KEUL, Thomas, 63579 Freigericht (DE); SHI, Huan, Shangcheng District, Hangzhou, 310000 (CN); LI, Haoran, 32427 Minden (DE); QU, Yvan-Yongfei, Hangzhou, 311201 (CN); LIU, Wei, Hangzhou, Zhejiang, 310000 (CN); LIU, Wendy, Qiantang District, Hangzhou, 310000 (CN)
(74) Representative: Maiwald GmbH

(56) References cited:
- CN-A- 103 762 966
- DE-A1- 102014 116 689
- US-A1- 2012 317 433

## Description

### FIELD OF THE INVENTION

The invention relates to power down circuitry and methods for process control systems.

### BACKGROUND

In the field of industrial process automation, controllers are typically provided with power down functionality which is operable to retain process values measured immediately prior to power failure for reuse upon power up. One example involves a conveyor belt which loads a ship with bulk material. Upon restart after power failure, the control application should continue with exactly the same value of load count as before the power failure. As process control systems increase in complexity, the challenge of implementing power down functionality in a cost effective manner becomes more challenging.

DE 10 2014 116689 A1 relates to a drive control for a DC motor in which energy stored in a buffer capacitor can be made usable for the continued operation of a control circuit in the event of failure of a supply voltage. If the voltage detected in the control circuit falls below a predetermined threshold level, a microcontroller activates a voltage converter so that energy for maintaining the operation of the control circuit is provided from the buffer capacitor to the control circuit.

US 2012/317433 relates to maintaining data integrity during power loss events. When a power monitor module detects power loss, a memory controller stores relevant data in flash memory. It teaches specifically writing only to the fast (LSB) pages of MLC NAND flash memory, which can be programmed more quickly and with less power than slow (MSB) pages, maximizing the use of limited power available from capacitors after power loss.

CN 103 762 966 discloses a power-failure memory circuit for use in home appliances. The circuit includes an IC chip, a memory cell with a voltage detection capacitor, and an erasable storage unit. The IC chip controls charging of the capacitor and, upon power loss, detects the voltage across the capacitor to determine whether to save current operating parameters into the erasable storage.

### SUMMARY

To better address one or more of these concerns, there is provided, in a first aspect of invention, power down circuitry as defined by appended claim 1.

In this way, the power down circuitry may be implemented using cost-effective, small-size, and/or readily-available components. No batteries are necessary and process control execution tasks are not hindered by cyclic storage of data in non-volatile memory. The data storage time of the process data to be retained is practically unlimited. Large amounts of data can be retained at moderate hardware costs.

The power voter may comprise a plurality of inputs each configured to receive power from a respective power source, wherein at least one of the power sources comprises the at least one capacitor bank. Another of the power sources may comprise an external power source, for example a cabinet power source. The power voter may comprise a plurality of diodes connected in a reverse series configuration with a common output. The power voter may be configured to select the highest voltage appearing at its inputs for provision at its output to the controller circuitry. In this way, the power voter is operable to provide bumpless bridging between power sources.

The power down circuitry may comprise a DC/DC converter configured to convert an input voltage provided by an external power source into a primary intermediate voltage for supplying power to the controller during normal operation. The at least one buffer capacitor meanwhile provides a secondary intermediate voltage for supplying power to the controller in the event of failure of an external power source. The level of the secondary intermediate voltage may be selected to be lower than the primary intermediate voltage such that the primary intermediate voltage is selected by the power voter during normal operation. In the event of power failure, reduction of the primary intermediate voltage causes the power voter to select the secondary intermediate voltage.

The power down circuitry may comprise power fail detection circuitry configured to generate a power fail detection signal upon power down. The power fail detection signal may be used by the logic circuitry for initiating the power down sequence. In one example, the logic circuitry is configured to initiate the power down sequence directly in response to receiving the power fail detection signal. In another example, the logic circuitry is configured to delay initiation of the power down sequence directly following receipt of the power fail detection signal. By delaying the power down sequence, normal operation may continue for a certain amount of time using energy sourced from the at least one buffer capacitor so as to bridge voltage dips from the external power source for more reliable operation of the process control system. The power fail detection circuitry may comprise a comparator configured to detect that the input voltage provided by the external power source is lower than a predefined threshold voltage level and correspondingly to generate the power fail detection signal. The power fail detection circuitry and/or the comparator form part of the DC/DC converter, in one example.

Step up to the higher voltage in this way may reduce the necessary dimensions of the at least one capacitor.

The power down circuitry may comprise a switch which is operable by the logic circuitry to cut power to one or more components to conserve energy during the power down sequence. The components to which power is to be cut may include the logic circuitry itself once its roll in coordinating the power down sequence has been fulfilled. The switch may receive a control signal from the logic circuitry. The control signal may be set per default to turn on the switch.

The logic circuitry may be configured to coordinate the transfer of the process data to the non-volatile memory in a blockwise manner. The logic circuitry may be configured to sort the process data for transfer to the non-volatile memory. The logic circuitry may be configured to sort and transfer the process data in parallel. The logic circuitry may be configured to transfer a first block of process data to the non-volatile memory while sorting a second, different block of process data in parallel, to mitigate time and energy costs of the data transfer.

According to a second aspect, there is provided a controller for a process control system, the controller comprising the power down circuitry of the first aspect. The controller may be configured to execute a control application for controlling an industrial process. In one example, logic circuitry of the power down circuitry may be implemented by the same logic circuitry which executes the control application. The control application may generate process data which may be obtained or extracted by the controller for retention upon power failure. The controller may be configured to store process data in non-volatile storage for a predetermined amount of time, for example at minimum for one hour after power failure. The controller may frequently update the process data to be retained during normal operation until power failure. For example, the controller may periodically place the process data to be retained in static/dynamic RAM, which has an infinitive number of writing cycles and a fast access time, before writing the process data into non-volatile storage (such as F-RAM, M-RAM or nvSRAM) upon power down.

According to a third aspect, there is provided a process control system comprising the power down circuitry of the first aspect and/or the controller of the second aspect.

According to a fourth aspect, there is provided an industrial automation system comprising the power down circuitry of the first aspect and/or the controller of the second aspect and/or the process control system of the third aspect.

According to a fifth aspect, there is provided a power down method as defined by appended claim 12.

The method of the fifth aspect may be (at least partially) computer implemented. Optional features of the first aspect may form part of any of the second-fifth aspects, mutatis mutandis.

According to a sixth aspect, there is provided a computing system configured to perform the method of the fifth aspect.

According to a seventh aspect, there is provided a computer program (product) comprising instructions which, when executed by a computing system, enable or cause the computing system to perform the method of the fifth aspect.

According to an eighth aspect, there is provided a computer-readable (storage) medium comprising instructions which, when executed by a computing system, enable or cause the computing system to perform the method of the fifth aspect. The computer-readable medium may be transitory or non-transitory, volatile or non-volatile.

By "sufficient" is meant that the energy stored in the at least one buffer capacitor is at least the amount of energy needed for the power down sequence and preferably more than necessary for the power down sequence.

By "(process) automation system" is meant an industrial plant or production plant comprising one or more pipelines, production lines, and/or assembly lines for transforming one or more educts into a product and/or for assembling one or more components into a final product.

By "process data" is meant any data used by the automation system in relation to the production process. In particular, the process data may comprise process values which are used in one or more control loops. Typically, such process values are stored in volatile memory during normal operation. The process data may additionally or alternatively comprise other data which are generated and/or used during operation, for example I/O signals, log data, configuration data, administration data, and/or error counters.

The term "obtaining", as used herein, may comprise, for example, receiving from another system, device, or process; receiving via an interaction with a user; loading or retrieving from storage or memory; measuring or capturing using sensors or other data acquisition devices.

The term "determining", as used herein, encompasses a wide variety of actions, and may comprise, for example, calculating, computing, processing, deriving, investigating, looking up (e.g., looking up in a table, a database or another data structure), ascertaining, and the like. Also, "determining" may comprise receiving (e.g., receiving information), accessing (e.g., accessing data in a memory), and the like. Also, "determining" may comprise resolving, selecting, choosing, establishing and the like.

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

The invention may include one or more aspects, examples or features in isolation or combination whether specifically disclosed in that combination or in isolation. Any optional feature or sub-aspect of one of the above aspects applies as appropriate to any of the other aspects.

The above-described aspects will become apparent from, and elucidated with, reference to the detailed description provided hereinafter.

### BRIEF DESCRIPTION OF THE DRAWINGS

A detailed description will now be given, by way of example only, with reference to the accompanying drawings, in which:-
FIG. 1 illustrates a process control system for controlling an industrial process;
FIG. 2 is a block diagram representing a controller of the process control system of FIG. 1 which uses capacitor-buffered energy for power fail handling;
FIG. 3 illustrates another example of the controller of FIG. 1;
FIG. 4 illustrates one example of a power down sequence; and
FIG. 5 illustrates a further example of the power down sequence which is rationalized for expedited execution.

### DETAILED DESCRIPTION

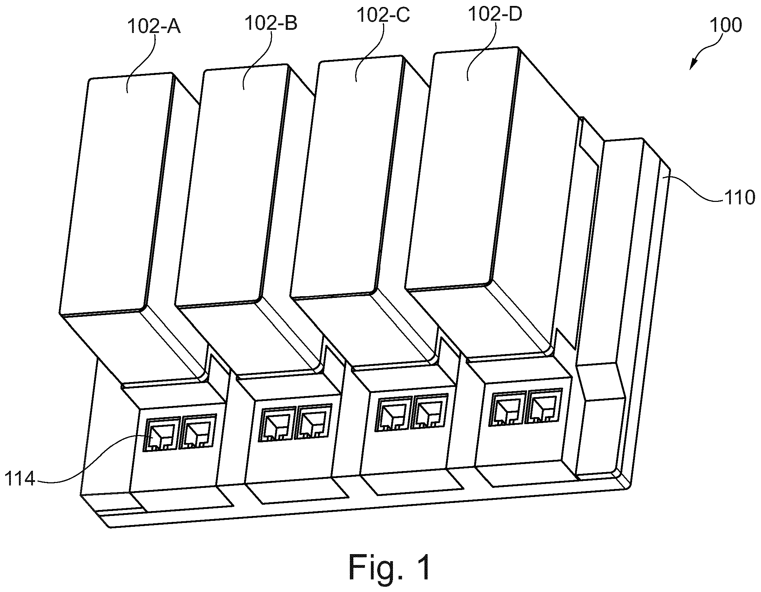

FIG. 1 illustrates a process control system 100 for controlling an industrial process carried out by an automation system (not shown). The process control system 100 comprises multiple controllers 102-A, 102-B, 102-C, 102-D, collectively referred to as controllers 102, which are physically and communicatively coupled to one another via a mounting termination unit (MTU) 110, commonly known as a backplane. The controllers 102 are configured to communicate with other components of the automation system, such as field devices, or an engineering tool as described herein. The engineering tool (typically implemented as a software package) is used to create configuration data for the process control system 100, which can be downloaded to the controllers 102. For the purposes of such communication, the controllers 102 are provided with ethernet ports, such as that illustrated at 114, together with associated communications interface circuitry. Each of the controllers 102 furthermore comprises its own network switch.

Each of the controllers 102 is configured to control a respective process carried out by the automation system (not shown). The process control system 100 may find application in any field of industry where process automation is desired, such as energy, oil and gas, chemical, petrochemical, and so on. The controllers 102 handle process control and monitoring for the automation system by receiving input signals from sensors and instruments, and outputting control signals for controlling plant equipment such as pumps, valves, conveyors, mixers, and heaters. Any such sensor, instrument or plant equipment may form part of one or more of the field devices. The controllers 102 are configured to execute process control applications to generate the control signals on the basis of the input signals. Each control application may comprise control logic instructing the respective controller how to respond to all input signals with appropriate control signals to maintain normal functioning of the process. In one non-limiting example, the control application conforms to the international standard IEC 61131. Each of the controllers 102 comprises logic circuitry configured to execute the respective control application. The logic circuitry may comprise a CPU, MCU, SoC, FPGA, DSP, and/or an Al-engine, together with any memory to be used in the processing of signals. The logic circuitry may be further configured to perform any one or more of the other operations described herein.

One or more of the controllers 102 are furthermore provided with power down functionality which is operable to retain process values measured immediately prior to power failure for reuse upon power up. It is desirable to implement the power down circuitry in a cost-effective manner using small size components which are readily maintainable and which are not subject to constraints on their use or transportation.

According to the present disclosure, power down circuitry of the controller 102 is implemented using cost-efficient components, including at least one buffer capacitor (e.g., a standard capacitor) for buffering sufficient energy to complete a power down sequence, together with non-volatile memory (e.g., an eMMC card, or flash memory) for saving application data after detection of power failure by the power down circuitry. During normal operation, the at least one capacitor (e.g., a capacitor bank) is charged to a default voltage (e.g., 45V). In case of power failure, the energy stored in the at least one capacitor is used to move the process data to be retained from the DRAM of the controller 102 to the non-volatile storage. The power down circuitry may be further configured to perform a power up sequence to resume execution of the control application following restoration of power, whereby the process data retained in the non-volatile storage is moved back into the DRAM of the controller 102.

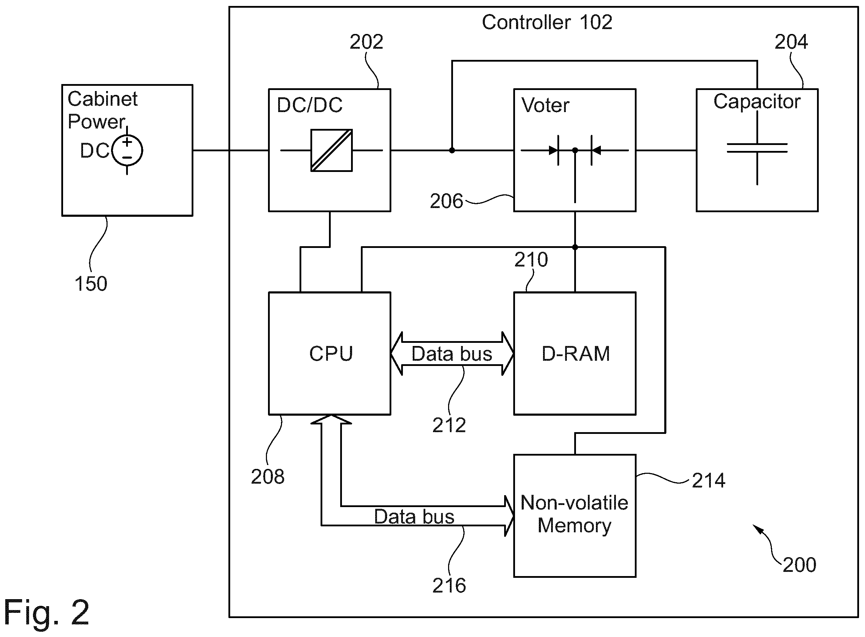

FIG. 2 is a block diagram illustrating the power down circuitry 200 of the controller 102. It will be understood that only those components of the controller 102 which are relevant for power fail handling are illustrated.

DC/DC converter 202 receives an input voltage (e.g., 24V) from an external power supply, referred to herein as a cabinet power supply 150, and converts the input voltage into a stabilized intermediate voltage (e.g., 5.1V), which is referred to as a primary or cabinet-side intermediate voltage. The DC/DC converter in one non-limiting example comprises a galvanic insulation, a current limiter, a fuse, and voltage monitoring circuitry.

Capacitor bank 204 stores energy for power fail handling. The stored energy in one limiting example is about 5 to 10 Joule. The charged capacitor bank 204 generates an intermediate voltage (e.g., 5.0V), which is referred to as a secondary or capacitor-side intermediate voltage.

Power voter 206 selects one of the two intermediate voltages for supply to circuitry of the controller 102, including at least its logic circuitry and memories, and optionally also certain peripherals. The power voter 206 is configured to select the highest voltage appearing at its inputs for provision to the controller circuitry. In the example illustrated in FIG. 2, the power voter 206 comprises two diodes connected in a reverse series configuration. The power voter 206 is thus operable to seamlessly bridge voltage dips in the cabinet-side intermediate voltage (e.g., 5.1V) by selecting the capacitor-side intermediate voltage (e.g., 5.0V). In a further example, the power voter 206 comprises power FETs with low passthrough resistance to keep losses caused by voltage drop low (e.g., in the mV range). By selecting a capacitor-side intermediate voltage which is lower than the cabinet-side intermediate voltage, the power down circuitry 200 functions in normal operation to supply the controller circuits with power delivered from the cabinet power supply 150 and not from the capacitor bank 204.

The logic circuitry 208 of the controller 102 comprises in this example a central processing unit (CPU) which communicates with dynamic random-access memory (DRAM) 210 via a data bus 212.

Non-volatile memory 214 provides storage capacity for the data to be retained upon power down. The non-volatile memory 214 in one example comprises an eMMC flash card. The CPU 208 communicates with the non-volatile memory via a data bus 216.

The power down sequence carried out by the power down circuitry 200 is as follows.

Beginning with normal operation in Step 1, the energy for controller 102 is delivered by the cabinet power supply 150. The capacitor bank 204 is fully charged with sufficient energy for the power down sequence to be completed. The CPU 208 executes the control application to generate and change process data during each control cycle. At least some of the process data are retain data which are to be used for the next control cycle or which are important for documenting the history of the control application. The retain data are stored in the DRAM but not necessarily in a linear address range, being spread over a wide address range of the DRAM.

Step 2 of the power down sequence comprises detection of power failure. The DC/DC converter 202 detects that the input voltage drops to a certain voltage level, for example a critical input voltage at which the DC/DC converter 202 can no longer generate the cabinet-side intermediate voltage reliably or safely, and generates a power fail detection signal. The DC/DC converter 202 may be provided for this purpose with a voltage monitor. The power fail detection signal may be low-pass filtered (e.g., about 20 ms) robustness against fluctuations in the input voltage. The power fail detection signal triggers the CPU 208 to begin power fail handling.

In Step 3, normal operation is finalised. The CPU 208 ensures that ongoing controller tasks are terminated fast and that no data inconsistencies occur.

In Step 4, peripherals such as as ethernet switches, physical layer components, superfluous CPU cores or FPGAs, oscillators, and interfaces are optionally turned off, to increase the amount of capacitor-stored energy which is available for the storage of the retain data. By "peripheral" is meant any component which is not involved in the transfer of retain data to non-volatile storage.

In Step 5, scattered retain data are optionally sorted. Retain data which are scattered in the DRAM 210 are sorted and stored in a linear address space of the DRAM 210, which also contains administration data for correct assignment of retain data to reestablish the application when power returns. For data integrity, a CRC checksum may be calculated for sections/blocks of compact (linear) stored retain data. For more efficient resource utilization, hardware-supported checksum calculations may be performed.

In Step 6, the retain data are transferred from DRAM 210 to the non-volatile memory 214. For example, the blocks of compact stored retain data are moved from the DRAM via the data bus 216, which may be a serial bus, to the non-volatile memory 214. Since data transfer rates between the CPU 208 and the non-volatile memory 214 are limited, regardless of which technology is used to implement them, the controller circuitry involved in the transfer must remain powered during this time.

In Step 7, subsequent to the transfer of the retain data, any remaining controller circuitry aside from the non-volatile storage 214 is turned off. To conserve energy, the CPU 208 may operate a switch to disconnect itself and the DRAM 210 from external power. In the case that the CPU 208 and DRAM 214 form part of a core or system on chip, it may be this component which is turned off. Simultaneously, the CPU 208 may reset its internal power supply (not shown) to prepare for the power up sequence to be carried out when external power returns. Additionally or alternatively, the CPU 208 may prepare an external reset circuit which provides the CPU/core with power when external power returns.

The power down sequence is thus completed with the retain values stored in non-volatile memory 214, optionally with data integrity ensured by one or more error detection and/or correction codes, such as CRC checksums. The non-volatile memory 214 remains powered by the capacitor bank 204. In one example, the non-volatile memory 214 remains powered for a predetermined amount of time (e.g., 0.5s) after receiving the last data transfer. The power consumption of the non-volatile memory 214 in this period is lower than that of the CPU 208, such that energy is conserved by separating the power supply to the non-volatile memory 214 from that of the CPU 208.

In a variant, the retain data are not transferred directly to the non-volatile memory 214 itself, but are first stored in a cache belonging to the non-volatile memory 214 which has a faster access time than the non-volatile memory 214.

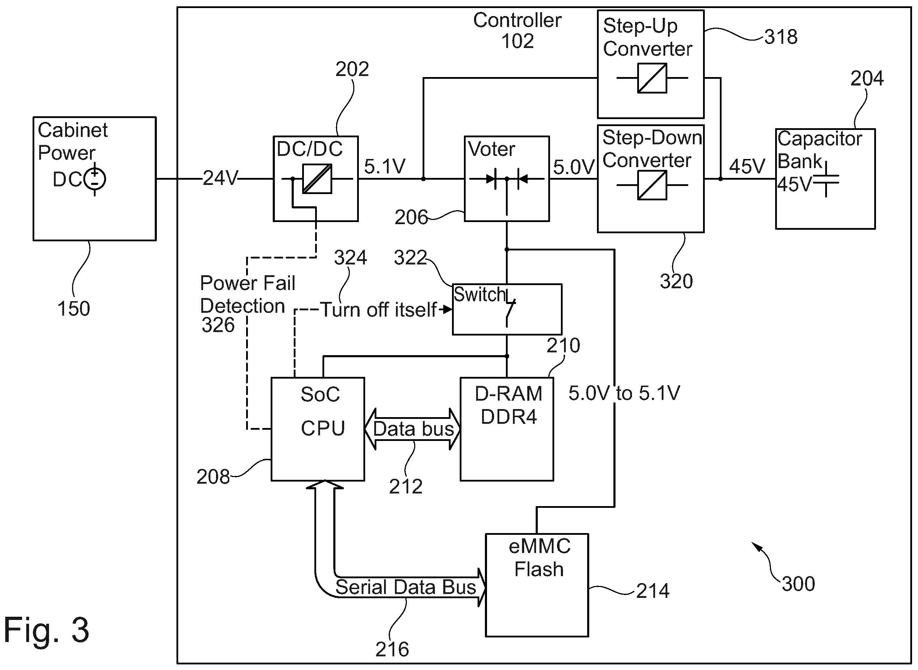

FIG. 3 illustrates the controller 102 comprising another example of power down circuitry 300 according to the present disclosure. The same reference numerals are used to indicate the same components as described with reference to FIG. 2. The power down circuitry 300 differs from the power down circuitry 200 in the following respects.

Step-up converter 318 increases the cabinet-side intermediate voltage to a higher level (e.g., 45V) and provides that voltage to the capacitor bank 204. Alternatively, the input to the step-up converter 318 can be tapped from the input voltage provided by the cabinet power supply 150 (e.g., 24V). The capacitor bank 204 is thus charged to a voltage which is higher than discharged voltages (for example 8 to 9 times higher), which facilitates utilization of a high ratio of the stored energy. Stated differently, the step up to the higher voltage reduces the necessary dimensions of capacitors for the same energy storage conditions.

Step-down converter 320 decreases the higher capacitor voltage to the capacitor-side intermediate voltage as described above (e.g., 5V).

Switch 322 is operable by the CPU 208 to turn off the CPU 208 and the DRAM 210 to conserve energy. The switch 322 receives a control signal 324 from the CPU 208. After power up, the control signal 324 is set per default to turn on the switch 322.

Power fail detection signal 326 is output by the DC/DC converter 202 for initiating the power down sequence. The signal 326 indicates that the energy to supply the controller 102 can no longer be delivered by the external power supply 150. In one example, a comparator is used to detect that the input voltage is lower than a predefined threshold voltage level.

### Example 1

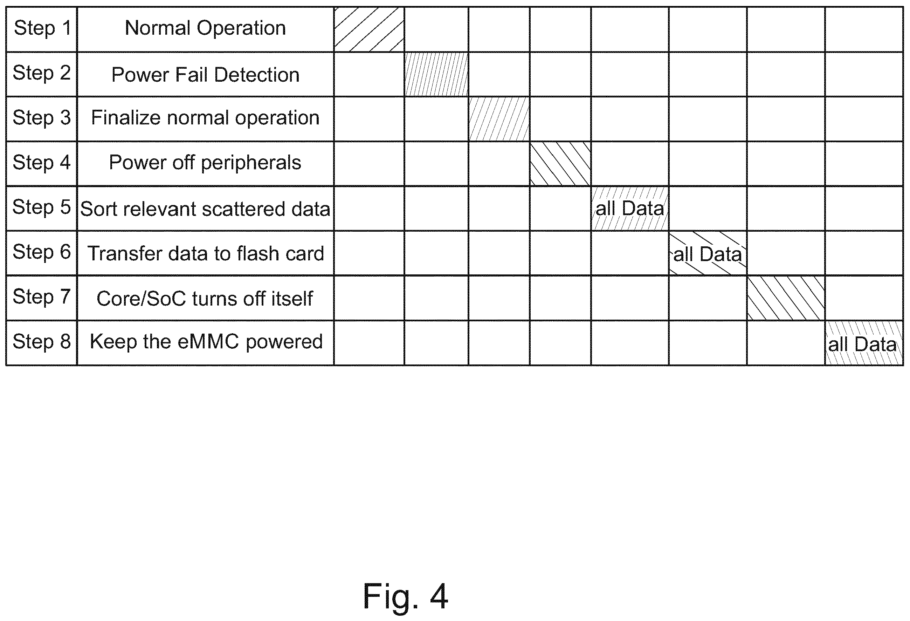

FIG. 4 illustrates one example of the power down sequence, in which the steps are performed sequentially, with each step commencing upon completion of the preceding step.

### Example 2

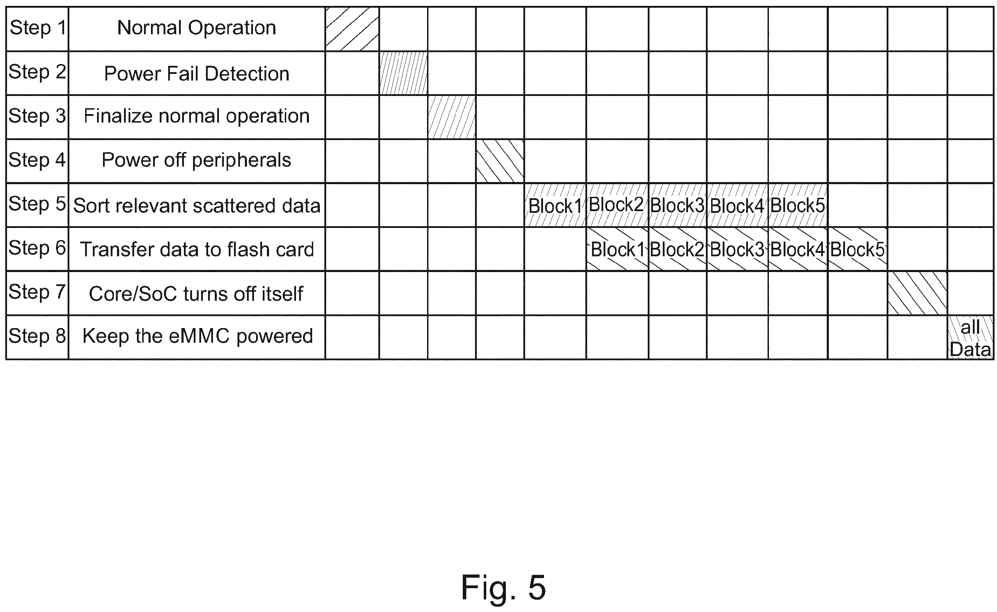

FIG. 5 illustrates a further example of the power down sequence which is rationalized for expedited execution. The sequence of FIG. 5 differs from that FIG. 4 in that Steps 5 and 6 are executed in parallel rather than serially. Stated differently, whereas Step 6 of FIG. 4 does not commence until Step 6 completes, in FIG. 5, parts or blocks of retain data are sorted in Step 5 and then immediately transferred in Step 6 while other blocks are being sorted in Step 5, to save time and energy. Energy savings permit utilization of smaller capacitors.

In any of the examples described herein, a power up sequence may be carried out when external power returns for recovery of the retain data. The power up sequence in the example of FIG. 3 may be started after the step-up voltage on the capacitor bank 204 reaches a setpoint voltage, so that the controller 102 is prepared for a further power failure. Alternatively, the control application may not generate new retain data before the capacitor bank 204 is sufficiently charged. The age of recovered retain data may be checked to ascertain that the retain values remain usable.

The logic circuitry 208 as described herein may be implemented using hardware, software, and/or firmware configured to perform any of the operations described herein. Hardware may comprise one or more processor cores, field-programmable gate arrays (FPGAs), application-specific integrated circuits (ASICs), application-specific standard products (ASSPs), system-on-a-chip systems (SOCs), complex programmable logic devices (CPLDs), etc. Software may be embodied as a software package, code, instructions, instruction sets and/or data recorded on at least one transitory or non-transitory computer readable storage medium. Firmware may be embodied as code, instructions or instruction sets and/or data hard-coded in memory devices (e.g., non-volatile memory devices).

If implemented in software, the functions can be stored on or transmitted over as one or more instructions or code on a computer-readable medium. Computer-readable media include computer-readable storage media. Computer-readable storage media can be any available storage media that can be accessed by a computer. By way of example, and not limitation, such computer-readable storage media can comprise FLASH storage media, RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal may be included within the scope of computer-readable storage media. Computer-readable media also includes communications media including any medium that facilitates transfer of a computer program from one place to another. A connection, for instance, can be a communications medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio and microwave are included in the definition of communications medium. Combinations of the above should also be included within the scope of computer-readable media.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features.

It has to be noted that embodiments of the invention are described with reference to different categories. In particular, some examples are described with reference to methods whereas others are described with reference to apparatus. However, a person skilled in the art will gather from the description that, unless otherwise notified, in addition to any combination of features belonging to one category, also any combination between features relating to different category is considered to be disclosed by this application. However, all features can be combined to provide synergetic effects that are more than the simple summation of the features.

While the invention has been illustrated and described in detail in the drawings and foregoing description, such illustration and description are to be considered exemplary and not restrictive. The invention is not limited to the disclosed embodiments.

The mere fact that certain measures are recited in mutually different dependent claims does not indicate that a combination of these measures cannot be used advantageously.

Any reference signs in the claims should not be construed as limiting the scope.

## Claims

1. Power down circuitry (300) for a controller (102) of a process control system, the power down circuitry comprising:
at least one buffer capacitor (204) for buffering sufficient energy to complete a power down sequence;
a power voter (206) configured to select the at least one buffer capacitor as energy source in response to detection of power failure;
non-volatile memory (214) for retaining process data following the detection of power failure;
logic circuitry (208) configured to coordinate transfer of the process data to the non-volatile memory during the power down sequence,
**characterized in that** the power down circuitry (300) further comprises:
a step-up converter (318) configured to increase an input voltage provided by an external power source (150) and/or a primary intermediate voltage provided by a DC/DC converter (202) to a higher voltage and to provide the higher voltage to the at least one buffer capacitor; and
a step-down converter (320) configured to decrease the higher voltage to a secondary intermediate voltage level for input to the power voter.

2. Power down circuitry according to claim 1, wherein the power voter (206) comprises a plurality of inputs each configured to receive power from a respective power source, wherein at least one of the power sources comprises the at least one buffer capacitor (204).

3. Power down circuitry according to claim 2, wherein another of the power sources comprises an external power source (150).

4. Power down circuitry according to claim 2 or 3, wherein the power voter (206) is configured to select the highest voltage appearing at its inputs for provision at its output to power the controller (102).

5. Power down circuitry according to any preceding claim, wherein the power voter (206) comprises a plurality of diodes connected in a reverse series configuration with a common output.

6. Power down circuitry according to any preceding claim, further comprising the DC/DC converter (202) configured to convert the input voltage provided by the external power source (150) into the primary intermediate voltage for supplying power to the controller (102) during normal operation, wherein the at least one buffer capacitor (204) provides a secondary intermediate voltage for supplying power to the controller in the event of failure of the external power source.

7. Power down circuitry according to claim 6, wherein the secondary intermediate voltage is selected to be lower than the primary intermediate voltage such that the primary intermediate voltage is selected by the power voter (206) during normal operation, and wherein, in the event of power failure, reduction of the primary intermediate voltage causes the power voter to select the secondary intermediate voltage.

8. Power down circuitry according to any preceding claim, further comprising power fail detection circuitry configured to generate a power fail detection signal (326) upon power down, wherein the power fail detection signal is used by the logic circuitry (208) for initiating the power down sequence.

9. Power down circuitry according to any preceding claim, further comprising a switch (322) which is operable by the logic circuitry (208) to cut power to one or more components to conserve energy during the power down sequence.

10. A controller (102) for a process control system, the controller comprising the power down circuitry (300) of any preceding claim.

11. A process control system (100) comprising the power down circuitry (300) of any of claims 1-9.

12. A power down method comprising:
buffering sufficient energy to complete a power down sequence using at least one buffer capacitor (204);
selecting the at least one buffer capacitor as energy source in response to detection of power failure;
coordinating the transfer of process data to non-volatile memory (214) during the power down sequence; and
retaining the process data in non-volatile memory following the detection of power failure, **characterized in that** the method is further comprising:
by a step-up converter (318), increasing an input voltage provided by an external power source (150) and/or a primary intermediate voltage provided by a DC/DC converter (202) to a higher voltage and providing the higher voltage to the at least one buffer capacitor; and
by a step-down converter (320), decreasing the higher voltage to a secondary intermediate voltage level for input to a power voter.

13. A computer-readable medium comprising instructions which, when executed by by the power down circuitry of claim 1, cause the power down circuitry to perform the method of claim 12.

## Patentansprüche

1. Abschaltschaltung (300) für eine Steuerung (102) eines Prozesssteuerungssystems, wobei die Abschaltschaltung umfasst:
mindestens einen Pufferkondensator (204) zum Puffern ausreichender Energie, um eine Abschaltsequenz abzuschließen;
einen Leistungsauswähler (206), der dazu eingerichtet ist, den mindestens einen Pufferkondensator als Energiequelle in Reaktion auf eine Erfassung eines Leistungsausfalls auszuwählen;
einen nichtflüchtigen Speicher (214) zum Beibehalten von Prozessdaten nach der Erfassung des Leistungsausfalls;
eine Logikschaltung (208), die dazu eingerichtet ist, eine Übertragung der Prozessdaten zu dem nichtflüchtigen Speicher während der Abschaltsequenz zu koordinieren,
**dadurch gekennzeichnet, dass** die Abschaltschaltung (300) ferner umfasst:
einen Aufwärtswandler (318), der dazu eingerichtet ist, eine von einer externen Leistungsquelle (150) bereitgestellte Eingangsspannung und/oder eine von einem DC/DC-Wandler (202) bereitgestellte primäre Zwischenspannung auf eine höhere Spannung zu erhöhen und die höhere Spannung dem mindestens einen Pufferkondensator bereitzustellen; und
einen Abwärtswandler (320), der dazu eingerichtet ist, die höhere Spannung auf einen sekundären Zwischenspannungspegel zur Eingabe in den Leistungsauswähler zu verringern.

2. Abschaltschaltung nach Anspruch 1, wobei der Leistungsauswähler (206) mehrere Eingänge umfasst, die jeweils dazu eingerichtet sind, Leistung von einer jeweiligen Leistungsquelle zu empfangen, wobei mindestens eine der Leistungsquellen den mindestens einen Pufferkondensator (204) umfasst.

3. Abschaltschaltung nach Anspruch 2, wobei eine andere der Leistungsquellen eine externe Leistungsquelle (150) umfasst.

4. Abschaltschaltung nach Anspruch 2 oder 3, wobei der Leistungsauswähler (206) dazu eingerichtet ist, die höchste an seinen Eingängen auftretende Spannung zur Bereitstellung an seinem Ausgang auszuwählen, um die Steuerung (102) mit Leistung zu versorgen.

5. Abschaltschaltung nach einem der vorhergehenden Ansprüche, wobei der Leistungsauswähler (206) mehrere Dioden umfasst, die in einer Rückwärts-Reihenschaltung mit einem gemeinsamen Ausgang verbunden sind.

6. Abschaltschaltung nach einem der vorhergehenden Ansprüche, ferner umfassend den DC/DC-Wandler (202), der dazu eingerichtet ist, die von der externen Leistungsquelle (150) bereitgestellte Eingangsspannung in die primäre Zwischenspannung umzuwandeln, um die Steuerung (102) während eines Normalbetriebs mit Leistung zu versorgen, wobei der mindestens eine Pufferkondensator (204) eine sekundäre Zwischenspannung bereitstellt, um die Steuerung im Fall eines Ausfalls der externen Leistungsquelle mit Leistung zu versorgen.

7. Abschaltschaltung nach Anspruch 6, wobei die sekundäre Zwischenspannung so gewählt ist, dass sie niedriger als die primäre Zwischenspannung ist, sodass die primäre Zwischenspannung während des Normalbetriebs durch den Leistungsauswähler (206) ausgewählt wird, und wobei im Fall eines Leistungsausfalls eine Verringerung der primären Zwischenspannung bewirkt, dass der Leistungsauswähler die sekundäre Zwischenspannung auswählt.

8. Abschaltschaltung nach einem der vorhergehenden Ansprüche, ferner umfassend eine Leistungsausfallerfassungsschaltung, die dazu eingerichtet ist, beim Abschalten ein Leistungsausfallerfassungssignal (326) zu erzeugen, wobei das Leistungsausfallerfassungssignal durch die Logikschaltung (208) zum Einleiten der Abschaltsequenz verwendet wird.

9. Abschaltschaltung nach einem der vorhergehenden Ansprüche, ferner umfassend einen Schalter (322), der durch die Logikschaltung (208) betätigbar ist, um Leistung zu einer oder mehreren Komponenten zu unterbrechen, um während der Abschaltsequenz Energie einzusparen.

10. Steuerung (102) für ein Prozesssteuerungssystem, wobei die Steuerung die Abschaltschaltung (300) nach einem der vorhergehenden Ansprüche umfasst.

11. Prozesssteuerungssystem (100), umfassend die Abschaltschaltung (300) nach einem der Ansprüche 1 bis 9.

12. Abschaltverfahren, umfassend:
Puffern ausreichender Energie, um eine Abschaltsequenz abzuschließen, unter Verwendung mindestens eines Pufferkondensators (204);
Auswählen des mindestens einen Pufferkondensators als Energiequelle in Reaktion auf eine Erfassung eines Leistungsausfalls;
Koordinieren der Übertragung von Prozessdaten zu einem nichtflüchtigen Speicher (214) während der Abschaltsequenz; und
Beibehalten der Prozessdaten in dem nichtflüchtigen Speicher nach der Erfassung des Leistungsausfalls,
**dadurch gekennzeichnet, dass** das Verfahren ferner umfasst:
durch einen Aufwärtswandler (318), Erhöhen einer von einer externen Leistungsquelle (150) bereitgestellten Eingangsspannung und/oder einer von einem DC/DC-Wandler (202) bereitgestellten primären Zwischenspannung auf eine höhere Spannung und Bereitstellen der höheren Spannung für den mindestens einen Pufferkondensator; und
durch einen Abwärtswandler (320), Verringern der höheren Spannung auf einen sekundären Zwischenspannungspegel zur Eingabe in einen Leistungsauswähler.

13. Computerlesbares Medium, umfassend Anweisungen, die, wenn sie durch die Abschaltschaltung nach Anspruch 1 ausgeführt werden, das Computersystem veranlassen, das Verfahren nach Anspruch 12 durchzuführen.

## Revendications

1. Circuiterie de mise hors tension (300) pour un contrôleur (102) d'un système de commande de processus, la circuiterie de mise hors tension comprenant :
au moins un condensateur tampon (204) destiné à stocker temporairement suffisamment d'énergie pour achever une séquence de mise hors tension ;
un circuit d'arbitrage d'alimentation (206) configuré pour sélectionner l'au moins un condensateur tampon comme source d'énergie en réponse à la détection d'une panne d'alimentation ;
une mémoire non volatile (214) destinée à conserver des données de processus à la suite de la détection d'une panne d'alimentation ;
une circuiterie logique (208) configurée pour coordonner le transfert des données de processus vers la mémoire non volatile pendant la séquence de mise hors tension,
la circuiterie de mise hors tension (300) étant **caractérisée en ce qu'**elle comprend en outre :
un convertisseur élévateur (318) configuré pour élever une tension d'entrée fournie par une source d'alimentation externe (150) et/ou une tension intermédiaire primaire fournie par un convertisseur continu-continu (202) jusqu'à une tension plus élevée et pour fournir la tension plus élevée à l'au moins un condensateur tampon ; et
un convertisseur abaisseur (320) configuré pour abaisser la tension plus élevée jusqu'à un niveau de tension intermédiaire secondaire destiné à être appliqué en entrée du circuit d'arbitrage d'alimentation.

2. Circuiterie de mise hors tension selon la revendication 1, dans laquelle le circuit d'arbitrage d'alimentation (206) comprend une pluralité d'entrées configurées chacune pour recevoir une alimentation provenant d'une source d'alimentation respective, au moins une des sources d'alimentation comprenant l'au moins un condensateur tampon (204).

3. Circuiterie de mise hors tension selon la revendication 2, dans laquelle une autre des sources d'alimentation comprend une source d'alimentation externe (150).

4. Circuiterie de mise hors tension selon la revendication 2 ou 3, dans laquelle le circuit d'arbitrage d'alimentation (206) est configuré pour sélectionner la tension la plus élevée présente à ses entrées afin de la fournir à sa sortie pour alimenter le contrôleur (102).

5. Circuiterie de mise hors tension selon l'une quelconque des revendications précédentes, dans laquelle le circuit d'arbitrage d'alimentation (206) comprend une pluralité de diodes connectées selon une configuration en série en sens inverses avec une sortie commune.

6. Circuiterie de mise hors tension selon l'une quelconque des revendications précédentes, comprenant en outre le convertisseur continu-continu (202) configuré pour convertir la tension d'entrée fournie par la source d'alimentation externe (150) en la tension intermédiaire primaire destinée à alimenter le contrôleur (102) pendant un fonctionnement normal, l'au moins un condensateur tampon (204) fournissant une tension intermédiaire secondaire destinée à alimenter le contrôleur en cas de panne de la source d'alimentation externe.

7. Circuiterie de mise hors tension selon la revendication 6, dans laquelle la tension intermédiaire secondaire est sélectionnée de manière à être inférieure à la tension intermédiaire primaire de sorte que la tension intermédiaire primaire soit sélectionnée par le circuit d'arbitrage d'alimentation (206) pendant un fonctionnement normal, et dans laquelle, en cas de panne d'alimentation, une diminution de la tension intermédiaire primaire amène le circuit d'arbitrage d'alimentation à sélectionner la tension intermédiaire secondaire.

8. Circuiterie de mise hors tension selon l'une quelconque des revendications précédentes, comprenant en outre une circuiterie de détection de panne d'alimentation configurée pour générer un signal de détection de panne d'alimentation (326) lors de la mise hors tension, le signal de détection de panne d'alimentation étant utilisé par la circuiterie logique (208) pour déclencher la séquence de mise hors tension.

9. Circuiterie de mise hors tension selon l'une quelconque des revendications précédentes, comprenant en outre un interrupteur (322) qui peut être actionné par la circuiterie logique (208) afin de couper l'alimentation d'un ou de plusieurs composants pour préserver l'énergie pendant la séquence de mise hors tension.

10. Contrôleur (102) pour un système de commande de processus, le contrôleur comprenant la circuiterie de mise hors tension (300) selon l'une quelconque des revendications précédentes.

11. Système de commande de processus (100) comprenant la circuiterie de mise hors tension (300) selon l'une quelconque des revendications 1 à 9.

12. Procédé de mise hors tension, comprenant :
le stockage temporaire, au moyen d'au moins un condensateur tampon (204), de suffisamment d'énergie pour achever une séquence de mise hors tension ;
la sélection de l'au moins un condensateur tampon comme source d'énergie en réponse à la détection d'une panne d'alimentation ;
la coordination du transfert de données de processus vers une mémoire non volatile (214) pendant la séquence de mise hors tension ; et
la conservation des données de processus dans la mémoire non volatile à la suite de la détection d'une panne d'alimentation, le procédé étant **caractérisé en ce qu'**il comprend en outre :
par un convertisseur élévateur (318), l'élévation d'une tension d'entrée fournie par une source d'alimentation externe (150) et/ou d'une tension intermédiaire primaire fournie par un convertisseur continu-continu (202) jusqu'à une tension plus élevée, et la fourniture de la tension plus élevée à l'au moins un condensateur tampon ; et
par un convertisseur abaisseur (320), l'abaissement de la tension plus élevée jusqu'à un niveau de tension intermédiaire secondaire destiné à être appliqué en entrée d'un circuit d'arbitrage d'alimentation.

13. Support lisible par ordinateur comprenant des instructions qui, lorsqu'elles sont exécutées par la circuiterie de mise hors tension selon la revendication 1, amènent la circuiterie de mise hors tension à réaliser le procédé selon la revendication 12.
